# FASCICULE DE BREVET EUROPEEN

(11) **EP 2 917 781 B1**
(45) Date de publication et mention de la délivrance du brevet: **01.07.2020**
(21) Numéro de dépôt: 13758925.5
(22) Date de dépôt: 30.07.2013
(51) Int. Cl.: G02F 1/1343, C03C 17/34, C03C 17/36, G02F 1/1334

(54) **SUPPORT ELECTROCONDUCTEUR POUR VITRAGE A DIFFUSION VARIABLE PAR CRISTAUX LIQUIDES, ET UN TEL VITRAGE**
ELEKTRISCH LEITENDER TRÄGER FÜR EINE VERGLASUNGSEINHEIT MIT VARIABLER FLÜSSIGKRISTALLINDUZIERTER STREUUNG SOWIE DERARTIGE VERGLASUNGSEINHEIT
ELECTRICALLY CONDUCTIVE CARRIER FOR A GLAZING UNIT WITH VARIABLE LIQUID-CRYSTAL-INDUCED SCATTERING, AND SUCH A GLAZING UNIT

(30) Priorité: 07.11.2012 FR 1202989
(43) Date de publication de la demande: 16.09.2015
(73) Titulaire: SAINT-GOBAIN GLASS FRANCE, 92400 Courbevoie (FR)
(72) Inventeur: STERNCHUSS, Juliette, 78100 Saint-Germain en Laye (FR); LETOCART, Philippe, 4730 Raeren (BE); ZHANG, Jingwei, 91300 Massy (FR); ALSCHINGER, Matthias, 60200 Compiegne (FR)
(74) Mandataire: Saint-Gobain Recherche
(86) Numéro de dépôt international: PCT/FR2013/051840
(87) Numéro de publication internationale: WO 2014/072596

(56) Documents cités:
- EP-A1- 1 653 276
- EP-A2- 0 964 288
- WO-A2-2009/083693
- WO-A2-2012/022876
- FR-A1- 2 939 240
- US-A1- 2006 261 335

## Description

L'invention concerne un vitrage à diffusion variable par cristaux liquides, doté d'une couche de cristaux liquides alternant de manière réversible entre un état transparent et un état non transparent, par application d'un champ électrique alternatif.

On connait des vitrages dont certaines caractéristiques peuvent être modifiées sous l'effet d'une alimentation électrique appropriée, tout particulièrement la transmission, l'absorption, la réflexion dans certaines longueurs d'ondes du rayonnement électromagnétique, notamment dans le visible et/ou dans l'infrarouge, ou encore la diffusion lumineuse.

Le vitrage électrocommandable à cristaux liquides peut être utilisé partout, tant dans le secteur de la construction que dans le secteur de l'automobile, chaque fois que la vue à travers le vitrage doit être empêchée à des moments donnés.

Les électrodes communément utilisées sont en oxyde mixte d'indium et d'étain (ITO en anglais). Pour se prémunir des court circuits générés par des impuretés conductrices de taille supérieure ou égale à la distance entre les électrodes, chacune des couches ITO peut être revêtue d'une couche diélectrique telle que SiO₂, Si₃N₄ comme évoqué dans le document US5808715, et dans le document EP 0 964288.

Un objet de l'invention consiste à développer un vitrage multiple à cristaux liquides encore plus fiable et robuste, sans pénaliser ses propriétés optiques et électriques.

A cet effet, la présente invention propose un vitrage à diffusion variable par cristaux liquides comportant un premier substrat transparent (en verre minéral ou organique) avec une face principale comportant un empilement de couches minces dans cet ordre :
- (directement sur la face principale ou sur une sous couche mince par exemple oxyde ou nitrure métallique) une électrode comportant une couche à base d'oxyde transparent électroconducteur (de préférence à base d'étain et d'indium), dite couche TCO, de préférence d'épaisseur e₀ comprise dans un domaine allant de 50 à 200 nm,
- une première couche barrière, à base de nitrure de silicium (SiNx, de préférence Si₃N₄) d'épaisseur e₁ d'au moins 5 nm, non dopé ou éventuellement dopé de préférence aluminium, et de préférence essentiellement constituée d'un nitrure de silicium éventuellement dopé de préférence aluminium,
- au-dessus de la première couche barrière (de préférence directement sur), une deuxième couche barrière, à base d'oxyde de silicium (SiOx, de préférence SiO₂) d'épaisseur e₂ d'au moins 30 nm, de préférence d'au moins 45 nm voire 50 nm, et encore plus préférentiellement inférieure ou égale à 80 nm, de préférence essentiellement constituée d'oxyde de silicium (silice), deuxième couche non dopée ou éventuellement dopé de préférence aluminium,
l'épaisseur e₁ est inférieure à e₂, et/ou e₁ est inférieure à 80nm
l'épaisseur cumulée e_{b} des première et deuxième couches barrières est supérieure ou égale à 50nm et inférieure ou égale à 150 nm et encore plus préférentiellement inférieure ou égale à 120nm.

Dans la présente invention, on entend par couche barrière une couche barrière aux courts circuits.

La Demanderesse a identifié plusieurs sources de court-circuit :
- les impuretés conductrices de taille supérieure ou égale à la distance entre les électrodes, déjà connues, par exemple des particules métalliques issues d'éclats de machines de manipulation des verres (Al, inox ...), ou des contaminants du verre (gouttes d'étain ...), ou encore des contaminants dans les mélanges du polymère et des cristaux liquides ;
- mais aussi des impuretés conductrices de taille inférieure à la distance entre les électrodes, de même origine, particulièrement nuisibles si de forme irrégulière ;
- des défauts non conducteurs mais avec une haute constante diélectrique car les cristaux liquides sont alors soumis à des très hauts champs électriques
- et une rugosité importante de la couche de TCO (produisant un effet de pointe ou spikes en anglais ...).

L'emploi d'au moins les deux couches barrières selon l'invention est plus efficace, face à ces sources multiples de courts circuits, que toutes les monocouches de l'art antérieur de par :
- la sélection des matériaux des couches barrière, et des épaisseurs minimales e₁, e₂ et e_{b} ;
- la multiplication des interfaces diélectriques qui va diminuer le nombre de défauts (trous, joint de grains, piqures ou pinholes ...) traversant l'épaisseur totale de couches au-dessus de TCO qui pourrait être des entrées pour les court-circuits.

Ces deux couches barrières présentent une permittivité diélectrique faible (typiquement inférieure à 10), une tension de claquage haute (typiquement supérieure à 4 MV/cm), et un mode de claquage non propagatif (« self healing » en anglais).

Pour des raisons d'ajustement optique, la deuxième couche barrière (SiOₓ) est choisie de plus bas-indice de réfraction (dans le visible) que la première couche barrière.

On préfère également limiter l'épaisseur e_{b} et d'e₁ pour simplifier les conditions de dépôt et assurer un bonne tenue mécanique. A l'inverse, fixer une épaisseur minimale plus élevée pour la deuxième couche contribue à rendre plus efficace la multicouche, en réduisant significativement la fréquence des courts circuits.

Avantageusement pour des contraintes optiques la deuxième couche barrière (SiOₓ) est de préférence la dernière couche, en particulier la dernière couche barrière, ou une dernière couche barrière distincte de la deuxième couche barrière est d'indice de réfraction compris entre 1,4 et 1,7 et même 1,4 et 1,55.

Dans la présente demande lorsqu'on parle d'une « succession de couches », de « couches successives », ou encore d'une couche située au-dessus ou en-dessous d'une autre couche, on se réfère toujours au procédé de fabrication de l'électrode au cours duquel les couches sont déposées les unes après les autres sur le substrat transparent. La première couche est donc celle qui est le plus proche du substrat, toutes les couches « suivantes » étant celles situées « au-dessus » de cette première, et « en-dessous » des couches déposées ensuite.

Par « couche » au sens de la présente invention, et en l'absence de précision, il faut comprendre qu'il peut y avoir une couche en un matériau unique (monocouche) ou plusieurs couches (multicouche), chacune en un matériau différent.

Au sens de la présente invention, en l'absence de toute indication, l'épaisseur correspond à l'épaisseur géométrique.

Au sens de la présente invention, une couche à base d'oxyde (respectivement à base de nitrure) d'élément(s) métallique(s) donné(s), l'expression à base veut dire que la proportion en poids de l'élément ou des éléments métalliques est d'au moins 50% en poids total de métal et de préférence au moins 70% en poids total de métal.

Au sens de l'invention, en l'absence de précision, le dopage d'une couche (oxyde ou nitrure) s'entend de préférence comme exposant une présence du dopant métallique dans une quantité inférieure à 10% en poids total de métal dans la couche et même plus préférentiellement inférieure à 6% voire à 5% en poids total de métal.

Au sens de la présente invention, dans une couche « essentiellement constituée » d'un oxyde (ou d'un nitrure) d'un ou de plusieurs éléments métalliques donnés et de dopants métalliques éventuels définis expressément, la proportion en poids d'autres éléments métalliques (distincts desdits éléments et des dopants) est de préférence inférieure à 10% en poids total de métal et encore plus préférentiellement inférieure ou égale à 5%. Autrement dit la proportion en poids desdits éléments métalliques et des dopants métalliques est de préférence supérieure à 90% en poids total de métal et encore plus préférentiellement supérieure ou égale à 95% en poids total de métal.

Par extension, le terme métal ou (élément ou dopant) métallique inclus le silicium et le bore et en plus de tous les éléments métalliques du tableau périodique (alcalins, alcalino terreux, de transition, métaux pauvres).

Naturellement, selon l'invention, une couche qui est « essentiellement constituée » d'un matériau donné peut comprendre d'autres éléments (impuretés, ...) du moment qu'ils ne modifient pas notablement les propriétés souhaitées de la couche.

Selon l'invention, une couche en un matériau est synonyme d'une couche essentiellement constituée de ce matériau.

On entend selon l'invention par couche mince une couche d'épaisseur (géométrique) inférieure à 300 nm.

Les couches notamment barrières sont de préférence obtenues par pulvérisation cathodique magnétron.

Les formules données ne préjugent pas de la stœchiométrie réelle des couches, et d'un éventuel dopage. En particulier le nitrure de silicium et/ou l'oxyde de silicium peut être dopé, par exemple à l'aluminium.

Les oxydes et nitrures peuvent ne pas être stœchiométriques (ils peuvent toutefois l'être), d'où l'utilisation dans les formules de l'indice « x », qui n'est bien entendu pas nécessairement le même pour toutes les couches.

Pour la première couche barrière à base nitrure de silicium, le nitrure de silicium peut être stœchiométrique en azote, sous-stœchiométrique en azote, ou encore sur-stœchiométrique en azote. Il est entendu que le nitrure de silicium peut être dopé, ou ne pas être stœchiométrique.

A titre d'exemple, le nitrure de silicium peut être dopé par l'aluminium et/ou d'autre(s) dopant(s) métallique(s), notamment dans le but de faciliter son dépôt par procédé de pulvérisation cathodique.

La première couche barrière est d'indice de réfraction (à 550nm) d'au moins 1,9 de préférence compris entre 1,9 et 2,1. Le nitrure de silicium peut contenir de l'oxygène (oxynitrure de silicium) en des teneurs suffisamment faibles pour que l'indice de réfraction de la couche reste dans les gammes susmentionnées.

La deuxième couche barrière à base d'oxyde de silicium est avantageusement une couche essentiellement constituée d'oxyde de silicium (autrement dit de silice). Il est entendu que la deuxième couche peut être dopée, ou ne pas être stœchiométrique. A titre d'exemple, la deuxième couche peut être dopée par l'aluminium et/ou d'autre(s) dopant(s) métallique(s), notamment dans le but de faciliter son dépôt par procédé de pulvérisation cathodique. La deuxième couche barrière est d'indice de réfraction (à 550nm) compris entre 1,4 et 1,7.

Dans le cas de dépôt chimique en phase vapeur (CVD), notamment lorsque le TCO est déposé aussi par CVD, la silice peut être dopée par des atomes de bore ou de phosphore, qui accélèrent le dépôt.

La deuxième couche barrière peut encore être dopée par des atomes de carbone ou même d'azote, en des teneurs suffisamment faibles pour que l'indice de réfraction de la couche reste dans la gamme susmentionnée. Une couche en oxycarbure de silicium par exemple déposée par CVD, est typiquement d'indice de réfraction 1,65. Une couche en silice est typiquement d'indice 1,48.

On préfère toutefois que la deuxième couche barrière ne soit pas nitrurée, à tout le moins déposée en atmosphère réactive N₂/O₂.

La deuxième couche barrière peut être la dernière couche de l'empilement, donc celle en contact avec la couche de cristaux liquides. Alternativement, au moins une autre couche mince peut être au-dessus de cette deuxième couche avec une fonctionnalité barrière et/ou une dernière couche mince sans fonctionnalité barrière.

On peut ainsi disposer à des fins de protection (mécanique etc), de préférence sur la deuxième couche barrière voire une autre couche barrière directement sur la deuxième couche barrière, une dernière couche, d'épaisseur inférieure à 15nm, 10nm ou même inférieure ou égale 5nm, par exemple à base d'oxyde de titane voire essentiellement constituée d'oxyde de titane dont la fonction principale est la protection mécanique, et sans d'effet barrière.

Une couche n'a pas d'effet barrière par exemple lorsque sa constante diélectrique est d'au moins 10 ou sa tension de claquage est inférieure à 4 MV/cm ou a un mode de claquage de type « propagatif » comme le TiO₂. On peut citer par exemple aussi la zircone ZrO₂, l'oxyde de tantale Ta₂O₅. Par la suite on qualifie cette fine couche de couche de protection.

De préférence :
- l'épaisseur totale eₜₒₜ de couches barrières est inférieure à 200nm, inférieure ou égale à 180nm ou même inférieure ou égale à 120nm ;
- l'épaisseur totale e' de couches sur l'ITO est inférieure à 200nm, inférieure ou égale à 180nm ou même inférieure ou égale 120nm.

Avantageusement, pour une barrière aux courts-circuits optimale :
- e₂ est dans une gamme allant de 30 à 100nm mieux encore allant de 35à 80nm et même de 40 à 70nm,
- e_{b} est de préférence inférieure ou égale à 120nm et de préférence e₁ est dans une gamme allant de 10 à 50nm mieux encore allant de 10 à 40nm,
- la deuxième couche barrière est de préférence la dernière couche barrière voire l'avant dernière couche barrière.

Dans un premier mode de réalisation préféré, simple et performant, e₂ est dans une gamme allant de 35nm à 80nm, e₁ est dans une gamme allant de 10 à 50nm.

De préférence dans ce premier mode :
- la deuxième couche barrière est de préférence la dernière couche barrière voire l'avant dernière couche barrière,
- la première couche barrière à base de nitrure de silicium est déposée sur et en contact avec la couche à base d'ITO,
- la deuxième couche barrière est quant à elle préférentiellement déposée sur et en contact avec la première couche barrière.

On préfère donc un empilement avec la séquence stricte suivante : TCO (ITO de préférence) / SiNₓ / SiOₓ (/couche de protection), avec e₁ de 10 à 40nm et e₂ de 40 à 70nm.

Toutefois, dans un deuxième mode de réalisation avantageux, l'empilement comprend une couche barrière, dite couche barrière additionnelle, à base d'oxyde mixte de zinc et d'étain (SnₓZn_{y}O dénommé par la suite SnZnO), de préférence essentiellement constituée d'oxyde et d'étain (non dopé ou éventuellement dopé), d'épaisseur e_{5'} d'au moins 5nm et inférieure à 50nm, encore plus préférentiellement de 10 à 30 nm qui est, pour des facilités d'ajustement de l'optique, entre les première et deuxième couches barrières, et de préférence en contact avec les première et deuxième couches barrières. La couche barrière additionnelle est d'indice de réfraction d'au moins 1,9 de préférence compris entre 1,9 et 2,1.

L'insertion de cette couche peu épaisse de SnZnO est susceptible de limiter l'extension spatiale des courts circuits. On a effet observé lors d'essais préliminaires avec des couches épaisses de SiO₂, Si₃N₄ et SnZnO (à 200nm) sur ITO que :
- la couche épaisse de SiO₂ est efficace mais donne des courts-circuits (en faible nombre) qui s'étendent sur moins d'1 cm, souvent quelques mm au plus,
- la couche de SnZnO est sept fois moins efficace que la couche SiO₂ de même épaisseur mais les court-circuits obtenus, même fréquents, sont alors de taille très limitée inférieure à quelques mm,
- la couche de Si₃N₄ est au moins aussi efficace que SiO₂ mais donne quelques courts-circuits qui s'étendent sur plusieurs cm de diamètre.

Cela peut donc permettre de rendre les rares courts circuits éventuels plus acceptables (moins visibles).

La première couche barrière est de préférence directement sur la couche ITO pour les propriétés optiques. Ainsi, on préfère un empilement avec la stricte séquence suivante : TCO (ITO de préférence) / SiNₓ / (SnZnO)/ SiOₓ (/couche de protection).

Dans la couche barrière de SnZnO, le pourcentage cumulé Sn+Zn en poids est de préférence d'au moins 85% en poids total de métal, mieux de 90% voire de 95%. Le rapport du nombre d'atomes de Sn au nombre d'atomes de Zn est de préférence compris entre 20/80 et 80/20, en particulier entre 30/70 et 70/30.

La couche barrière de SnZnO peut être dopée par exemple au Sb voire In. Elle est de préférence dénuée d'indium.

Dans une réalisation, l'empilement peut comprendre sur la deuxième couche barrière, une autre couche barrière, dite surcouche barrière, à base de nitrure de silicium d'épaisseur e'₃ d'au moins 5nm et inférieure à 50nm, mieux de 15nm à 35 nm, la deuxième couche barrière étant de préférence l'avant-dernière couche barrière.

Cette autre surcouche barrière est d'indice de réfraction (à 550nm) compris entre 1,9 et 2.1. Le nitrure de silicium peut contenir de l'oxygène (oxynitrure de silicium) en des teneurs suffisamment faibles pour que l'indice de réfraction de la couche reste dans la gamme susmentionnée. De préférence, elle est identique à la première couche barrière.

Ainsi, on préfère un empilement avec la stricte séquence suivante (n supérieur ou égal à 1) :
- TCO (ITO de préférence) / SiNₓ / SiOₓ/ SiNₓ (/couche de protection)
- TCO (ITO de préférence) /SiNₓ/ SnZnO/ SiOₓ/ SiNₓ (/couche de protection)
- ou même TCO (ITO de préférence) / [SiNₓ / SiOₓ]ₙ fois /SiNₓ / SnZnO/ SiOₓ/ SiNₓ(/couche de protection), avec n supérieur ou égal à 1.

Dans une réalisation, l'empilement peut comprendre entre la couche TCO et la première couche barrière une couche barrière dite autre sous couche barrière à base d'oxyde de silicium d'épaisseur e'₄ d'au moins 5nm et inférieure à 50nm, mieux de 15nm à 35 nm.

Ainsi, on préfère un empilement avec la stricte séquence suivante (n supérieur ou égal à 1:
- TCO (ITO de préférence) / SiOₓ/ SiNₓ / SiOₓ(/couche de protection)
- TCO (ITO de préférence) /SiOₓ/ SiNₓ/ SnZnO / SiOₓ (/couche de protection)
- ou même TCO (ITO de préférence) / [SiNₓ/SiOₓ/]ₙ fois SiNₓ/ SnZnO/ SiOₓ (/couche de protection), avec n supérieur ou égal à 1.

Dans un mode de réalisation ; l'empilement comprend entre la couche TCO et la première couche barrière dans cet ordre :
- une troisième couche barrière à base de nitrure de silicium (SiNₓ, de préférence Si₃N₄) d'épaisseur e₃ d'au moins 5nm et inférieure à 50nm, éventuellement dopé de préférence aluminium et de préférence essentiellement constituée d'un nitrure de silicium, éventuellement dopé de préférence aluminium
- une quatrième couche barrière à base d'oxyde de silicium (SiOₓ, de préférence SiO₂) d'épaisseur e₄ d'au moins 5nm et inférieure à 50nm, de préférence essentiellement constituée d'oxyde de silicium ou silice, non dopée ou éventuellement dopé de préférence aluminium.

Naturellement, on préfère que la troisième couche barrière soit en matériau identique à la première couche barrière (réalisé à partir de la même cible, dans les mêmes conditions de dépôt). Naturellement on préfère que la quatrième couche barrière soit en matériau identique à la deuxième couche barrière (réalisé à partir de la même cible, dans les mêmes conditions de dépôt).

La troisième couche barrière est d'indice de réfraction d'au moins 1,9 de préférence compris entre 1,9 et 2,1. Comme la première couche, le nitrure de silicium peut contenir de l'oxygène (oxynitrure de silicium) en des teneurs suffisamment faibles pour que l'indice de réfraction de la couche reste dans les gammes susmentionnées.

La quatrième couche barrière est d'indice de réfraction compris entre 1,4 et 1,7. Il est entendu que la silice peut être dopée, ou ne pas être stœchiométrique. A titre d'exemple, la silice peut être dopée par les atomes d'aluminium ou d'autres, dans le but de faciliter son dépôt par procédé de pulvérisation cathodique. Comme la deuxième couche, la quatrième couche peut encore être dopée par des atomes de carbone ou même d'azote, en des teneurs suffisamment faibles pour que l'indice de réfraction de la couche reste dans la gamme susmentionnée. On préfère toutefois que la quatrième couche ne soit pas nitrurée, à tout le moins déposée en atmosphère réactive N₂/O₂. Dans le cas de dépôt chimique en phase vapeur (CVD), notamment lorsque le TCO est déposé aussi par CVD (et aussi la deuxième couche barrière), la silice peut être dopée par des atomes de bore ou de phosphore, qui accélèrent le dépôt.

La multiplication des interfaces renforce l'effet barrière et de préférence :
- e₃ est dans une gamme allant de 10 à 50nm, mieux 15 à 30 nm
- e₄ est dans une gamme allant de 10 à 50nm, mieux 15 à 30 nm,
et éventuellement e3<e4, la deuxième couche barrière étant de préférence la dernière couche barrière voire la dernière couche.

Pour les propriétés optiques, la troisième couche barrière est de préférence directement sur la couche TCO. Ainsi, on préfère un empilement avec la stricte séquence suivante :
- TCO (ITO de préférence) / SiNₓ / SiOₓ/ SiNₓ / SiOₓ (/couche de protection),
- TCO (ITO de préférence) / SiNₓ /SiOₓ/ SiNₓ / SnZnO / SiOₓ (/couche de protection)
- ou TCO (ITO de préférence) / SiNₓ / SnₓZn_{y}O /SiOₓ / SiNₓ / SnZnO / SiOₓ (/couche de protection).

Eventuellement l'empilement comprend entre la couche TCO et la troisième couche barrière au moins une fois la séquence suivante couche barrière à base de nitrure de silicium d'épaisseur d'au moins 5nm et inférieure à 50nm et mieux 15 à 30 nm / couche barrière à base d'oxyde de silicium d'épaisseur d'au moins 5nm et inférieure à 50nm (et mieux 15 à 30 nm).

Ainsi, on préfère un empilement avec la stricte séquence suivante, avec n supérieur ou égal à 1 :
- TCO (ITO de préférence) / [SiNₓ / SiOₓ/]_{nfois} / SiNₓ / SiOₓ (/couche de protection)
- ou TCO (ITO de préférence) / SiNₓ / SiOₓ/]_{nfois} / SiNₓ / (SnZnO) / SiOₓ (/couche de protection).

On peut également disposer, entre le substrat et la couche TCO un empilement de couches, de neutralisation. De telles couches (au moins deux couches) permettent d'influer sur l'aspect en réflexion du vitrage, notamment sur sa couleur en réflexion. Une fois le support électroconducteur revêtu de la couche de cristaux liquides (et même une fois rajouté un autre support électroconducteur identique), on obtient des couleurs de préférence neutres, légèrement bleutées ou vertes, caractérisées par des coordonnées colorimétriques a*, b* proches de 0, a*, b* négatives ou a* négative et b* légèrement positif, sont préférées à des couleurs violet rose, rouge (a* plus positive).

Pour la neutralité en couleur en réflexion du vitrage commutable, on préfère a* et b* dans l'intervalle (-8, +8) et mieux encore entre (-5, +5).

Dans un mode de réalisation préféré, l'empilement comprend dans cet ordre sur la face principale sous la couche TCO :
- une première sous-couche à base de nitrure de silicium (SiNₓ, de préférence Si₃N₄) éventuellement dopé de préférence aluminium, d'épaisseur e_{y} de 5 à 50nm, ou mieux de 10nm à 35nm, de préférence (directement) en contact avec la face principale et de préférence essentiellement constituée d'un nitrure de silicium éventuellement dopé de préférence aluminium ;
- une deuxième sous-couche à base d'oxyde de silicium (SiOₓ, de préférence SiO₂), d'épaisseur e_{z} de 10 à 50nm, ou mieux de 20nm à 50nm, de préférence essentiellement constituée d'oxyde de silicium, sous couche non dopée ou éventuellement dopé de préférence aluminium de préférence en contact avec la couche TCO.

Le meilleur ajustement est obtenu par e_{y} de 10 à 35nm, e_{z} de 20 à 50nm e₁ de 10 à 40nm et e₂ est de 40 à 70nm.

Pour la première sous-couche en nitrure de silicium, le nitrure de silicium peut être stœchiométrique en azote, sous-stœchiométrique en azote, ou encore sur-stœchiométrique en azote. A titre d'exemple, le nitrure de silicium peut être dopé par l'aluminium ou d'autres, dans le but de faciliter son dépôt par des procédés de pulvérisation cathodique La première sous-couche est d'indice de réfraction (à 550nm) est d'au moins 1,9 de préférence compris entre 1,9 et 2,1. Le nitrure de silicium peut contenir de l'oxygène (oxynitrure de silicium) en des teneurs suffisamment faibles pour que l'indice de réfraction de la première sous-couche reste dans les gammes susmentionnées.

La deuxième sous-couche à base d'oxyde de silicium est avantageusement une couche essentiellement constituée d'oxyde de silicium (autrement dit de silice). Il est entendu que la silice peut être dopée, ou ne pas être stœchiométrique. A titre d'exemple, la silice peut être dopée par l'aluminium ou d'autres, dans le but de faciliter son dépôt par des procédés de pulvérisation cathodique. La deuxième sous-couche peut encore être dopée par des atomes de carbone ou même d'azote, en des teneurs suffisamment faibles pour que l'indice de réfraction de la deuxième sous-couche reste dans la gamme susmentionnée. On préfère toutefois que cette deuxième sous-couche ne soit pas nitrurée, à tout le moins déposée en atmosphère réactive N₂/O₂. La deuxième sous couche est d'indice de réfraction (à 550nm) compris entre 1,4 et 1,7.

Dans le cas de dépôt chimique en phase vapeur (CVD), notamment lorsque le TCO est déposé aussi par CVD, la deuxième sous-couche peut être dopée par des atomes de bore ou de phosphore, qui accélèrent le dépôt. La deuxième sous couche à base d'oxyde de silicium peut être la dernière couche sous TCO. Alternativement, au moins une autre couche mince peut être déposée au-dessus de cette deuxième couche.

On préfère choisir pour l'empilement des couches d'oxyde de silicium toutes de matière identique et des couches de nitrure de silicium toutes de matière identique.

On peut intercaler entre la première et la deuxième sous couche une couche dite de lissage à base d'oxyde mixte de zinc et d'étain d'épaisseur e_{f'} d'au moins 5nm et inférieure à 50nm et de préférence de 10 à 30 nm qui a une fonction (principale) de lissage de par son caractère amorphe. Les épaisseurs e_{y} et e_{z} restent inchangées.

Dans la couche de lissage SnZnO, le pourcentage cumulé Sn+Zn en poids est d'au moins 85% en poids total de métal et de préférence 90% voire 95%. Le rapport du nombre d'atomes de Sn au nombre d'atomes de Zn est de préférence compris entre 20/80 et 80/20, en particulier entre 30/70 et 70/30. La couche de lissage de SnZnO peut être dopée par exemple au Sb voire In. Elle est de préférence dénuée d'indium.

Dans un mode de réalisation combinant efficacité aux courts circuits et neutralité en réflexion (ou teinte légèrement verte ou bleu), l'empilement comprend:
- une première sous couche à base de nitrure de silicium d'épaisseur e_{y} de 5 à 50nm et mieux 10nm à 40nm de préférence directement sur la face principale ;
- une deuxième sous couche à base d'oxyde de silicium avec d'épaisseur e_{z} de 10 à 50nm et mieux e_{y} de 20 à 50nm éventuellement directement sur la première sous-couche ;
- la couche TCO de préférence directement sur la deuxième sous couche ;
- la première couche barrière directement sur la couche de TCO avec e₁ dans une gamme allant de 10 à 40nm ;
- la deuxième couche barrière avec e₂ dans une gamme allant de 35nm à 80nm, mieux de 40 à 70nm qui est la dernière couche barrière, de préférence directement sur la première couche barrière.

Les différents modes de réalisation préférés décrits ci-avant peuvent bien entendu être combinés entre eux. Toutes les combinaisons possibles ne sont pas explicitement décrites dans le présent texte pour ne pas l'alourdir inutilement. Quelques exemples d'empilements particulièrement préférés (sans préciser l'éventuel dopage des couches barrière et des sous couches) directement sur verre (minéral de préférence) sont donnés ci-après :
- SiNₓ / SiOₓ / TCO (ITO de préférence) / SiNₓ / (SnZnO) / SiOₓ
- SiNₓ / SiOₓ / TCO (ITO de préférence) / SiNₓ / SnZnO / SiOₓ / (protection type TiOx)
- SiNₓ / (SnZnO)/ SiOₓ / TCO (ITO de préférence) / SiNₓ / (SnZnO) / SiOₓ / (protection type TiOₓ)

Comme déjà indiqué, toute couche barrière selon l'invention à base de nitrure de silicium ou à base d'oxyde de silicium peut être dopée à l'aluminium. Pour le nitrure de silicium dopé aluminium, le pourcentage en poids d'aluminium est de préférence jusqu'à 20% voire 15% ou même 10% en poids total de métal, voire en poids de l'ensemble silicium et aluminium. Pour l'oxyde de silicium dopé aluminium, le pourcentage en poids d'aluminium est de préférence jusqu'à 20% voire 15% ou même 10% en poids total de métal, voire en poids de l'ensemble silicium et aluminium.

Le substrat peut être plan ou courbe, et en outre rigide, flexible ou semi-flexible.

Ses faces principales peuvent être rectangulaires, carrées ou même de toute autre forme (ronde, ovale, polygonale...). Ce substrat peut être de grande taille par exemple de surface supérieure à 0,02 m² voire même 0,5 m² ou 1 m².

Le substrat transparent peut présenter de préférence une transmission lumineuse T_{L} supérieure ou égale à 70%, de préférence supérieure ou égale à 80% voire à 90%. Le substrat est de préférence transparent et incolore. Le substrat peut être verrier, en verre minéral ou organique, est de préférence transparent et incolore.

Il peut s'agit alors d'un verre minéral clair ou extra-clair. Un verre clair contient typiquement une teneur pondérale en oxyde de fer de l'ordre de 0,05 à 0,2%, tandis qu'un verre extra-clair contient généralement environ 0,005 à 0,03% d'oxyde de fer.

Le substrat, notamment en verre minéral, peut être toutefois coloré, par exemple en bleu, vert, gris ou bronze.

Le substrat transparent, par exemple coloré ou teinté, peut en effet présenter de préférence une transmission lumineuse T_{L} supérieure ou égale à 10% - par exemple dans un contexte où le milieu du côté de la face extérieure du substrat (opposée à la face avec l'électrode) est très éclairé -, et de préférence est supérieure ou égale à 40%.

Le substrat en verre minéral est de préférence de type silico-sodo-calcique mais il peut également être en verre de type borosilicate ou alumino-borosilicate. L'épaisseur du substrat en verre minéral est généralement comprise dans un domaine allant de 0,5 mm à 19 mm, de préférence de 0,7 à 9 mm, notamment de 2 à 8 mm, voire de 4 à 6 mm. Il en est de même, le cas échéant, pour d'autres feuilles de verre du vitrage multiple.

Le substrat de verre minéral est de préférence du type flotté, c'est-à-dire susceptible d'avoir été obtenu par un procédé consistant à déverser le verre fondu sur un bain d'étain en fusion (bain « float »). Dans ce cas, l'empilement peut aussi bien être déposé sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre.

De préférence, le substrat muni de l'empilement selon l'invention n'est pas trempé thermiquement.

Le substrat peut être en matière plastique. Le substrat peut être, notamment, une couche à base de polyéthylène téréphtalate (PET), de polyéthylène naphtalate (PEN), de polycarbonate, de polyuréthane, de polyméthacrylate de méthyle, de polyamide, de polyimide, de polymère fluoré tel que l'éthylène tétrafluoroéthylène (ETFE), le polyfluorure de vinylidène (PVDF), le polychlorotrifluoréthylène (PCTFE), l'éthylène de chlorotrifluoréthylène (ECTFE), les copolymères éthylène-propylène fluorés (FEP).

En variante, ce peut être un intercalaire de feuilletage assurant une liaison avec un substrat rigide ou flexible. Cet intercalaire de feuilletage polymère peut être, notamment, une couche à base de polybutyral de vinyle (PVB), d'éthylène vinylacétate (EVA), de polyéthylène (PE), de polychlorure de vinyle (PVC), d'uréthane thermoplastique, de polyuréthane PU, de ionomère, d'adhésif à base de polyoléfine, de silicone thermoplastique ou en résine pluri ou mono-composants, réticulable thermiquement (époxy, PU) ou aux ultraviolets (époxy, résine acrylique).

On peut même concevoir la structure suivante :
Verre minéral/ intercalaire de feuilletage en matière thermoplastique / support électroconducteur (substrat PET de préférence / empilement)/couche de cristaux liquides.

La T_{L} du support électroconducteur (substrat/empilement), en particulier non coloré (teinté), est de préférence d'au moins supérieure ou égale à 70%, de préférence supérieure ou égale à 80%.

Le support électroconducteur selon l'invention est de préférence obtenu par un procédé en plusieurs étapes. Les couches de l'empilement sont déposées sur le substrat, qui se présente alors généralement sous la forme d'une grande feuille de verre (minéral) de 3,2^{∗}6m², ou directement sur le ruban de verre pendant ou juste après le processus de flottage, puis le substrat est découpé aux dimensions finales du vitrage. Après façonnage des bords, on fabrique ensuite le vitrage commutable à cristaux liquides, décrits plus loin.

Les différentes couches de l'empilement peuvent être déposées sur le substrat par tout type de procédé de dépôt de couche mince. Il peut par exemple s'agir de procédés, pyrolyse (liquide ou solide), dépôt chimique en phase vapeur (CVD), notamment assisté par plasma (PECVD en anglais), éventuellement sous pression atmosphérique (APPECVD), évaporation voire de type sol-gel.

De préférence, les couches de l'empilement, au moins les couches barrières, sont obtenues par pulvérisation cathodique, notamment assistée par un champ magnétique (procédé magnétron). Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

La couche de TCO est de préférence d'épaisseur adaptée pour avoir une résistance (« intrinsèque ») par carré inférieure ou égale à 150Ω/□, de préférence inférieure ou égale à 120Ω/□.

La couche de TCO est alimentée électriquement via des moyens d'amenée de courant de préférence métalliques (à base d'argent, de cuivre etc) de préférence sous forme d'au moins deux bandes (métalliques) espacées sur/le long de deux bords opposés de la couche TCO, que la couche TCO soit de forme générale à coins ou ronde.

La couche d'un oxyde transparent électroconducteur est de préférence une ou une couche d'oxyde d'étain et d'indium (ITO). D'autres couches sont possibles, parmi lesquelles les couches minces :
- à base d'oxyde d'indium et de zinc (appelées « IZO »), d'oxyde d'indium de galium et de zinc (IGZO)
- à base d'oxyde de zinc dopé, de préférence au gallium ou à l'aluminium (AZO, GZO), à base d'oxyde de titane dopé au niobium, à base de stannate de cadmium ou de zinc,
- à base d'oxyde d'étain dopé au fluor (SnO₂:F), à base d'oxyde d'étain dopé à l'antimoine.

Dans le cas de l'oxyde de zinc dopé à l'aluminium, le taux de dopage (c'est-à-dire le poids d'oxyde d'aluminium rapporté au poids total) est de préférence inférieur à 3%. Dans le cas du gallium, le taux de dopage peut être plus élevé, typiquement compris dans un domaine allant de 5 à 6%.

Dans le cas de l'ITO, le pourcentage atomique de Sn est de préférence compris dans un domaine allant de 5 à 70%, notamment de 10 à 60%.

Pour les couches à base d'oxyde d'étain dopé au fluor, le pourcentage atomique de fluor est de préférence d'au plus 5%, généralement de 1 à 2%.

L'ITO est particulièrement préféré ou même IZO, AZO, GZO ou IGZO. Aisément déposées par un procédé de pulvérisation cathodique, notamment assisté par champ magnétique, appelé « procédé magnétron », ces couches se distinguent par une plus faible rugosité que par CVD.

Un des avantages de l'oxyde d'étain dopé au fluor est en revanche sa facilité de dépôt par dépôt chimique en phase vapeur (CVD), et peut être mis en oeuvre sur la ligne de production de verre plat par flottage. Dans un mode de réalisation, les couches de l'empilement sont obtenues par dépôt chimique en phase vapeur, directement sur la ligne de production de la feuille de verre par flottage. Le dépôt est réalisé par pulvérisation de précurseurs au travers de buses, sur le ruban de verre chaud. Le dépôt des différentes couches peut se faire à différents endroits de la ligne : dans l'enceinte de flottage, entre l'enceinte de flottage et l'étenderie, ou dans l'étenderie. Les précurseurs sont généralement des molécules organométalliques ou du type halogénures.

A titre d'exemples, on peut citer pour l'oxyde d'étain dopé au fluor le tétrachlorure d'étain, le trichlorure de mono-butyl étain (MTBCL), l'acide trifluoroacétique, l'acide fluorhydrique. L'oxyde de silicium peut être obtenu à l'aide de silane, de tétraéthoxysilane (TEOS), ou encore d'hexamethyldisiloxane (HDMSO), en utilisant éventuellement un accélérateur tel que le triéthylphosphate.

L'indice de réfraction de la couche d'un oxyde transparent électroconducteur est compris dans un domaine allant de 1,7 à 2,5.

L'invention a aussi pour objet un support électroconducteur selon l'invention avec une couche de cristaux liquides d'épaisseur micronique.

On peut utiliser tous les systèmes à cristaux liquides connus sous les termes de « NCAP » (Nematic Curvilinearly Aligned Phases en anglais) ou « PDLC » (Polymer Dispersed Liquid Cristal en anglais) ou « CLC » (Cholesteric Liquid Cristal en anglais) ou NPD-LCD (Non-homogenous Polymer Dispersed Liquid Crystal Display en anglais).

On peut utiliser des cristaux liquides multistables et en particulier des smectiques bistables, par exemple comme détaillé dans le brevet EP2256545, qui commutent sous l'application d'un champ électrique alternatif sous forme impulsionnelle et qui restent dans l'état commuté jusqu'à l'application d'une nouvelle impulsion.

On peut également utiliser, par exemple, les gels à base de cristaux liquides cholestériques contenant une faible quantité de polymère réticulé, comme ceux décrits dans le brevet WO-92/19695. Plus largement, on peut donc choisir des « PSCT » (Polymer Stabilized Cholesteric Texture en anglais).

L'invention a enfin pour objet un vitrage à diffusion variable par cristaux liquides, présentant :
- le support électroconducteur tel que décrit précédemment ;
- sur ledit support, une couche contenant des cristaux liquides dispersés en (micro)gouttelettes dans de la matière polymère, la couche de cristaux liquides alternant de manière réversible entre un état transparent et un état translucide typiquement par application d'un champ électrique alternatif (sinusoïdal, impulsionnel...), couche d'épaisseur de 5 à 60 µm en de préférence de 8 µm et inférieure à 40µm, soit entre 5 et 40 µm et contenant des espaceurs (transparents)
- un autre support électroconducteur de préférence tel que décrit précédemment comportant un autre substrat doté d'un autre empilement avec au moins une autre électrode, empilement en contact avec la couche de cristaux liquides
le substrat du (premier) support et l'autre substrat du deuxième support étant maintenues en bordure de leurs faces en regard par un joint de préférence organique.

On peut même concevoir les structures suivantes :
- (premier) support électroconducteur selon l'invention avec substrat en verre minéral/couche de cristaux liquides/autre empilement transparent/autre support en verre minéral
- verre/intercalaire/ substrat PET/empilement selon l'invention/couche de cristaux liquides/autre empilement transparent/autre support en PET / intercalaire/ verre minéral.

Naturellement les cristaux liquides peuvent s'étendre sensiblement sur toute la surface du vitrage (hors émargeage), ou sur (au moins) une zone restreinte, éventuellement être sur plusieurs zones.

On peut utiliser le vitrage à diffusion variable par cristaux liquides tel que défini précédemment comme vitrage dans des véhicules ou des bâtiments.

Le vitrage à diffusion variable par cristaux liquides selon l'invention peut être utilisé notamment :
- comme cloison interne (entre deux pièces ou dans un espace) dans un bâtiment, dans un moyen de locomotion terrestre, aérien, aquatique (entre deux compartiments, dans un taxi etc),
- comme porte vitrée, fenêtre, plafond, dallage (sol, plafond),
- comme rétroviseur de véhicule, vitrage latéral, toit d'un moyen de locomotion terrestre, aérien, aquatique,
- comme écran de projection,
- comme façade de magasin, vitrine notamment d'un guichet.

Naturellement, le vitrage selon l'invention peut former tout ou partie d'une cloison et autre fenêtre (type imposte etc).

En abaissant l'épaisseur de la couche de cristaux liquides (et donc la quantité de mélange actif encapsulé) en dessous de 15 µm, on réduit le coût de matière.

Par ailleurs, les espaceurs peuvent être de préférence en une matière plastique transparente. Les espaceurs déterminent (grossièrement) l'épaisseur de la couche de cristaux liquides. On préfère par exemple des espaceurs en polyméthacrylate de méthyle (PMMA).

Les espaceurs sont de préférence en matière d'indice optique (sensiblement) égal à l'indice optique de (la matrice polymérique de) la couche de cristaux liquides. Les espaceurs sont par exemple sous forme de billes.

Pour la fabrication du vitrage on peut se référer au document WO2012/028823 divulgue un vitrage multiple à cristaux liquides comprenant :
- des première et deuxième feuilles de verre plan flotté maintenues en bordure de leurs faces internes par un joint en époxy,
- sur les faces internes des première et deuxième feuilles de verre, des première et deuxième électrodes sous forme de couches électriquement conductrices transparentes en ITO dotées d'alimentation en énergie,
- et, entre les première et deuxième électrodes, une couche PDLC (Polymer Dispersed Liquid Crystal en anglais) contenant des cristaux liquides, tel que le composé 4-((4-Éthyle-2,6-difluorophényl)-éthinyl)-4'-propylbiphényl et 2-Fluor-4,4'-bis(trans-4-propylcyclohexyl)-biphenyl par exemple vendu par la société Merck sous la référence MDA-00-3506, dispersé en microgouttelettes dans de la matière polymère et contenant des espaceurs transparents, la couche PDLC alternant de manière réversible entre un état transparent et un état translucide par application d'un champ électrique alternatif.

Le revêtement de cristaux liquides est réalisé à l'aide d'une opération appelée remplissage goutte à goutte.

La matière qui va former le joint adhésif est de même appliquée en cordon sous forme non polymérisée, directement le long du bord de la feuille de verre avant ou après la dépose de la couche à cristaux liquides avec la matrice non polymérisée.

Ensuite, est opéré un calandrage ou en variante un pressage.

Les polymérisations de la matière pour le joint et de la matrice sont réalisées ensuite.

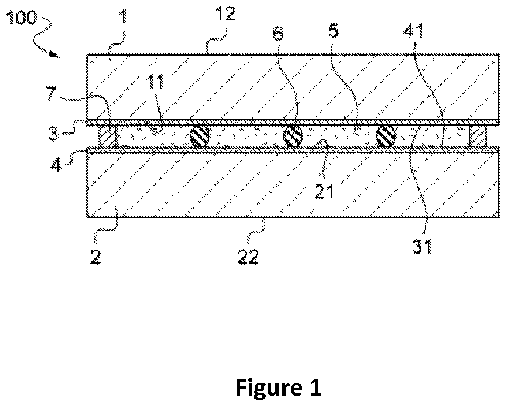

D'autres détails et caractéristiques de l'invention apparaîtront de la description détaillée qui va suivre, faite en regard du dessin annexé, la figure 1 représentant une vue en coupe schématique d'un vitrage à diffusion variable par cristaux liquides avec un support électroconducteur selon l'invention.

L'exemple de réalisation représenté dans la figure 1 montre la conception du vitrage commutable à cristaux liquides selon l'invention.

Sur deux feuilles de verre flotté 1 et 1' (ou en variante sur du plastique tel que du PET) sont disposées sur les faces internes 11, 21 des empilements de couches minces 3, 4 de surface externe 31, 41 incluant des électrodes réalisées en oxyde d'indium et d'étain (ITO).

Plus précisément l'empilement comprend au moins deux couches minces barrières aux courts-circuits déposées sur la couche ITO comme détaillé ci-après.

Et de préférence pour une neutralité en couleurs du vitrage commutable, l'empilement comprend au moins deux sous-couches minces diélectriques sous la couche ITO comme détaillé ci-après.

Une couche 5 de cristaux liquides est située entre les empilements 3 et 4. Plus précisément, la couche 5 de cristaux liquides est par exemple de type PDLC et contient des cristaux liquides sous forme de microgouttelettes dispersées dans une matrice en polymère. La couche 5 contient aussi des espaceurs sphériques en polymère transparent. L'épaisseur de la couche 5 est par exemple de 20 µm et peut varier de 5 à 60 µm typiquement.

On peut utiliser des cristaux liquides tel que le composé 4-((4-Éthyle-2,6-difluorophényl)-éthinyl)-4'-propylbiphényl et 2-Fluor-4,4'-bis(trans-4-propylcyclohexyl)-biphenyl par exemple vendu par la société Merck sous la référence MDA-00-3506.

Sur le bord, la couche de cristaux liquides 5 est entourée par un joint adhésif 7 en polymère réticulé qui sert en même temps à relier les feuilles de verre 1, 1' dotées des électrodes de manière ferme et permanente.

A l'état « OFF », c'est-à-dire avant l'application d'une tension électrique, ce vitrage à cristaux liquides 100 est translucide, c'est-à-dire qu'il transmet optiquement mais n'est pas transparent. Dès qu'une tension sinusoïdale est appliquée entre les deux électrodes, la couche 5 passe à l'état transparent, c'est-à-dire celui dans lequel la vision n'est pas empêchée.

Naturellement pour certaines applications, on peut alternativement souhaiter qu'à l'état « ON », le vitrage électrocommandable soit teinté. Pour ce faire, un ou les substrats sont teintés ou on rajoute un élément teinté, par exemple un film plastique teinté, ou un contre verre teinté feuilleté avec l'un des substrats en verre minéral (par du PVB, EVA etc) ou un intercalaire teinté.

### EXEMPLES

En exemple Ex1, sur un verre silicosodocalcique de 4mm (verre Planilux de SGGF ou en alternative Diamant) on a réalisé l'empilement suivant : ITO (60nm) / Si₃N₄ (15nm) / SiO₂ (60nm).

En exemple Ex2, sur un verre silicosodocalcique de 4mm (verre Planilux de SGGF) on a réalisé l'empilement suivant : Si₃N₄ (15nm) / SiO₂ (30nm)/ ITO (60nm) / Si₃N₄ (35nm) / SiO₂ (48nm).

En exemple Ex3, sur un verre silicosodocalcique de 4mm (verre Planilux de SGGF) on a réalisé l'empilement suivant: SiO₂ (40nm)/ ITO (120nm) / Si₃N₄ (15nm) / SiO₂ (60nm).

En exemple Ex4, sur un verre silicosodocalcique de 4mm (verre Planilux de SGGF) on a réalisé l'empilement suivant: Si₃N₄ (15nm) / SiO₂ (40nm)/ ITO (120nm) / Si₃N₄ (15nm) / SiO₂ (60nm).

En exemple Ex5, sur un verre silicosodocalcique de 4mm (verre Planilux de SGGF) on a réalisé l'empilement suivant : Si₃N₄ (25nm) / SiO₂ (40nm)/ ITO (60nm) / Si₃N₄ (35nm) / SiO₂ (60nm).

Plus précisément, la couche de nitrure de silicium et la couche de silice contiennent de l'aluminium.

Les couches ont été déposées par pulvérisation (pulvérisation dite « cathodique magnétron »). Les conditions de dépôt pour chacune des couches sont les suivantes :
- les couches à base de Si₃N₄:Al sont déposées par pulvérisation réactive à l'aide d'une cible en silicium et aluminium, dans une atmosphère argon/azote,
- les couches à base de SiO₂:Al sont déposées par pulvérisation réactive à l'aide d'une cible en silicium et aluminium, dans une atmosphère argon/ oxygène,
- les couches à base d'ITO sont déposées à l'aide d'une cible céramique dans une atmosphère argon oxygène en variante.

Les conditions de dépôt sont détaillées dans le tableau 1 suivant :

**Tableau 1**

| Couche | Cible employée | Pression de dépôt | Gaz | Indice de réfraction à 550 nm |
|---|---|---|---|---|
| Si₃N₄:Al | Si:Al à 92:8 % en poids | 2.10⁻³ mbar | N₂ /(Ar + N₂) à 40% | 2,0 |
| SiO₂:Al | Si:Al à 92:8 % en poids | 2.10⁻³ mbar | O₂ /(Ar + O₂) à 45% | 1,5 |
| ITO | Oxyde d'In 90% en poids | 2,5.10⁻³mbar | O₂ <4% et Ar> 96% | 2 |
| | Oxyde de Sn 10% en poids | | | |

La T_{L} des supports électroconducteurs Ex1 à Ex4 et la résistance par carré sont donnés dans le tableau 2 suivant :

**Tableau 2**

| Exemples | R_{c}(ohm.carré) | TL(%) |
|---|---|---|
| Ex1 | 91 | 88,0 |
| Ex2 | 140 | 88,8 |
| Ex3 | 117 | 87,0 |
| Ex4 | 105 | 87,3 |
| Ex5 | 105 | 88,0 |

Sur les vitrages à diffusion variable à base des cristaux liquides réalisés avec les exemples Ex1 à Ex4, on mesure le rendement des courts-circuits Rcc qui est le pourcentage du vitrage à cristaux liquides de 1m² sans court-circuit après commutation au voltage indiqué.

Dans la série de tests réalisés, Rcc est proche de 100% à 30V et supérieur à 70% à 90V contre 40% et 0% pour un verre revêtu d'une couche ITO et contre 70% et 0% par opposition une couche de SiO₂ de 60nm.

On mesure aussi la T_{L} et les valeurs optiques mesurées sur des vitrages à cristaux liquides (dits vitrage CL) à l'état ON qui sont répertoriés dans le tableau 3 suivant :

**Tableau 3**

| exemples | TL | L*T | a*T | b*T | R_{L} | L*R | a*R | b*R | abs |
|---|---|---|---|---|---|---|---|---|---|
| Vitrage CL avec Ex1 | 73,9 | 88,9 | -1,3 | 0,5 | 20,2 | 52,0 | -3,7 | 6,2 | 6,0 |
| Vitrage CL avec Ex2 | 83,7 | 93,3 | -3,5 | 6,3 | 9,5 | 36,9 | 2,9 | -5,0 | 6,8 |
| Vitrage CL avec Ex3 | 81,2 | 92,2 | -4,2 | 15,2 | 10,4 | 38,5 | 3,7 | -21,5 | 8,4 |
| Vitrage CL avec Ex4 | 81,9 | 92,5 | -4,9 | 12,3 | 9,7 | 37,3 | 6,8 | -14,3 | 9,7 |

Les vitrages CL avec Ex1 et Ex2 sont neutres en couleur en réflexion : a* et b* dans l'intervalle -8, +8.

Le vitrage CL avec Ex4 est gris bleu (couleur neutre mais intense) et le vitrage CL avec Ex1 est vert.

Dans une variante, on intercale entre la première et la deuxième couche barrière une troisième couche barrière en oxyde de zinc et d'étain d'épaisseur égale 20 nm et réalisée à partir d'une cible métallique de zinc et d'étain, sous atmosphère oxydante. Les conditions de dépôt sont détaillées dans le tableau 4 suivant :

**Tableau 4**

| Couche | Cible employée | Pression de dépôt | Gaz | Indice de réfraction à 550 nm |
|---|---|---|---|---|
| SnZnO | Sn:Zn à 64:36% en poids | 3,5.10⁻³ mbar | O₂ /(Ar + O₂) à 39% | 2 |

Dans une variante (alternative ou cumulative), on ajoute sur la deuxième couche barrière une couche de protection en oxyde de titane d'épaisseur égale à 5 nm à partir d'une cible métallique, en atmosphère oxydante. Cette couche a pour effet d'améliorer les propriétés mécaniques. Les conditions de dépôt sont détaillées dans le tableau 5 suivant :

**Tableau 5**

| Couche | Cible employée | Pression de dépôt | Gaz | Indice de réfraction à 550 nm |
|---|---|---|---|---|
| TiO₂ | Ti | 2,5.10⁻³ mbar | O₂ /(Ar + O₂) à 10% | 2,5 |

On peut utiliser un autre TCO de préférence déposé par pulvérisation en reprenant les couches barrières, et de préférence celles de neutralisation, précitées.

Pour des raisons d'optiques on préfère que la dernière couche barrière soit à base d'oxyde de silicium et qu'elle soit la deuxième couche barrière.

## Revendications

1. Vitrage à diffusion variable par cristaux liquides (100) comportant un support électroconducteur présentant un premier substrat transparent (1) avec une face principale (11) comportant un empilement de couches minces (3) dans cet ordre:
- une électrode comportant une couche à base d'oxyde transparent électroconducteur, dite couche TCO,
- une première couche barrière, à base de nitrure de silicium d'épaisseur e₁ d'au moins 5 nm,
et sur le support, une couche contenant des cristaux liquides dans de la matière polymère
**caractérisé en ce que** l'empilement comprend, au-dessus de la première couche barrière, une deuxième couche barrière, à base d'oxyde de silicium d'épaisseur e₂ d'au moins 30 nm,
**en ce que** l'épaisseur e₁ est inférieure ou égale à e₂ et/ou e₁ est inférieure à 80nm, et **en ce que** l'épaisseur cumulée e_{b} des première et deuxième couches barrières est supérieure ou égale à 50nm et inférieure à 150nm.

2. Vitrage à diffusion variable par cristaux liquides (100) selon la revendication 1 **caractérisé en ce que** e₂ est dans une gamme allant de 30 à 100nm, e_{b} est de préférence inférieure ou égale à 120nm.

3. Vitrage à diffusion variable par cristaux liquides (100) selon l'une des revendications précédentes **caractérisé en ce que** e₂ est dans une gamme allant de 35nm à 80nm, e₁ est dans une gamme allant de 10 à 50nm.

4. Vitrage à diffusion variable par cristaux liquides (100) selon l'une des revendications précédentes **caractérisé en ce que** l'empilement (3) comprend entre les première et deuxième couches barrières, une couche barrière, dite couche barrière additionnelle, à base d'oxyde de zinc et d'étain d'épaisseur e_{5'} d'au moins 5nm et inférieure à 50nm.

5. Vitrage à diffusion variable par cristaux liquides (100) selon l'une des revendications précédentes **caractérisé en ce que**, la deuxième couche barrière est la dernière couche barrière ou **en ce que** l'empilement (3) comprend sur la deuxième couche barrière, une autre couche barrière, dite surcouche barrière, à base de nitrure de silicium d'épaisseur e'₃ d'au moins 5nm et inférieure à 50nm.

6. Vitrage à diffusion variable par cristaux liquides (100) selon l'une des revendications précédentes **caractérisé en ce que** l'empilement (3) comprend entre la couche TCO et la première couche barrière une couche barrière, dite autre sous couche barrière, à base d'oxyde de silicium d'épaisseur e'₄ d'au moins 5nm et inférieure à 50nm.

7. Vitrage à diffusion variable par cristaux liquides (100) selon l'une des revendications précédentes **caractérisé en ce que** l'empilement (3) comprend entre la couche TCO et la première couche barrière dans cet ordre :
- une troisième couche barrière à base de nitrure de silicium d'épaisseur e₃ d'au moins 5nm et inférieure à 50nm,
- une quatrième couche barrière à base d'oxyde de silicium d'épaisseur e₄ d'au moins 5nm et inférieure à 50nm,
et éventuellement l'empilement comprend entre la couche TCO et la troisième couche barrière au moins une fois la séquence suivante : couche barrière à base de nitrure de silicium d'épaisseur d'au moins 5nm et inférieure à 50nm/ couche barrière à base d'oxyde de silicium d'épaisseur d'au moins 5nm et inférieure à 50nm séquence éventuellement répétée au moins une fois.

8. Vitrage à diffusion variable par cristaux liquides (100) selon l'une des revendications précédentes **caractérisé en ce que** l'empilement (3) comprend dans cet ordre sur la face principale (11) sous la couche TCO :
- une première sous-couche à base de nitrure de silicium d'épaisseur e_{y} de 5 à 50nm de préférence directement sur la face principale,
- une deuxième sous-couche à base d'oxyde de silicium d'épaisseur e_{z} de 10 à 50nm.

9. Vitrage à diffusion variable par cristaux liquides selon la revendication 8 **caractérisé en ce que** e_{y} est de 10 à 35nm, e_{z} est de 20 à 50nm, e₁ est de 10 à 40nm et e₂ est de 40 à 70nm.

10. Vitrage à diffusion variable par cristaux liquides (100) selon l'une des revendications 8 ou 9 **caractérisé en ce que** l'empilement (3) comprend entre la première sous-couche et la deuxième sous-couche une couche, dite de lissage, à base d'oxyde mixte de zinc et d'étain d'épaisseur e_{f'} d'au moins 5nm et inférieure à 50nm.

11. Vitrage à diffusion variable par cristaux liquides (100) selon l'une des revendications précédentes **caractérisé en ce que** le support électroconducteur comprend directement sur la deuxième couche barrière ou sur une couche dite de protection, ladite couche contenant des cristaux liquides dans de la matière polymère.

12. Vitrage à diffusion variable par cristaux liquides selon l'une des revendications précédentes **caractérisé en ce que** le substrat (1) est un verre minéral éventuellement teinté.

13. Vitrage à diffusion variable par cristaux liquides selon l'une des revendications précédentes **caractérisé en ce que** la couche à base d'oxyde transparent électroconducteur dite couche TCO est choisie parmi une couche à base d'oxyde de zinc dopé de préférence à l'aluminium et/ou au gallium, une couche à base d'oxyde d'étain dopé de préférence au fluor et/ou à l'antimoine, une couche à base d'oxyde d'étain et d'indium, une couche à base d'oxyde d'étain et de zinc, une couche à base d'oxyde d'étain de zinc et d'indium.

14. Vitrage à diffusion variable par cristaux liquides selon l'une des revendications précédentes **caractérisé en ce que** la couche à base d'oxyde transparent électroconducteur dite couche TCO est une couche à base d'oxyde d'étain et d'indium.

15. Vitrage à diffusion variable par cristaux liquides (100) selon l'une des revendications précédentes **caractérisé en ce qu'**il présente :
- ladite couche (5) contenant des cristaux liquides dispersés en gouttelettes dans de la matière polymère,
- un deuxième support électroconducteur comportant un autre substrat (2) doté d'un autre empilement (4) avec au moins une autre électrode, empilement en contact avec la couche de cristaux liquides.

16. Vitrage à diffusion variable par cristaux liquides (100) selon la revendication précédente **caractérisé en ce que** l'autre électrode comporte :
- une couche à base d'oxyde transparent électroconducteur, dite couche TCO
- une première couche barrière, à base de nitrure de silicium d'épaisseur e₁ d'au moins 5 nm,
et l'autre empilement comprend, au-dessus de la première couche barrière, une deuxième couche barrière, à base d'oxyde de silicium d'épaisseur e₂ d'au moins 30 nm, l'épaisseur e₁ est inférieure ou égale à e₂ et/ou e₁ est inférieure à 80nm,et **en ce que** l'épaisseur cumulée e_{b} des première et deuxième couches barrières est supérieure ou égale à 50nm et inférieure à 150nm.

## Patentansprüche

1. Verglasung (100) mit variabler flüssigkristallinduzierter Streuung, umfassend einen elektrisch leitenden Träger mit einem ersten transparenten Substrat (1) mit einer Hauptfläche (11), die einen Stapel dünner Schichten (3) in dieser Reihenfolge umfasst:
- eine Elektrode, die eine Schicht auf Basis eines transparenten elektrisch leitenden Oxids, eine sogenannte TCO-Schicht, umfasst,
- eine erste Sperrschicht auf Basis von Siliciumnitrid mit einer Dicke e₁ von mindestens 5 nm,
und auf dem Träger eine Schicht, die Flüssigkristalle in Polymermaterial enthält
**dadurch gekennzeichnet, dass** der Stapel über der ersten Sperrschicht eine zweite Sperrschicht auf Basis von Siliciumoxid mit einer Dicke e₂ von mindestens 30 nm umfasst,
dass die Dicke e₁ kleiner oder gleich e₂ ist, und/oder e₁ kleiner als 80 nm ist, und dass die kumulative Dicke e_{b} der ersten und zweiten Sperrschicht größer oder gleich 50 nm, und kleiner als 150 nm ist.

2. Verglasung (100) mit variabler flüssigkristallinduzierter Streuung nach Anspruch 1, **dadurch gekennzeichnet, dass** e₂ in einem Bereich von 30 bis 100 nm liegt, e_{b} vorzugsweise kleiner oder gleich 120 nm ist.

3. Verglasung (100) mit variabler flüssigkristallinduzierter Streuung nach einem der vorhergehenden Ansprüche, **dadurch gekennzeichnet, dass** e₂ in einem Bereich von 35 nm bis 80 nm liegt, e₁ in einem Bereich von 10 bis 50 nm liegt.

4. Verglasung (100) mit variabler flüssigkristallinduzierter Streuung nach einem der vorhergehenden Ansprüche, **dadurch gekennzeichnet, dass** der Stapel (3) zwischen der ersten und zweiten Sperrschicht eine Sperrschicht, eine sogenannte zusätzliche Sperrschicht, auf Basis von Zink- und Zinnoxid mit einer Dicke e_{5'} von mindestens 5 nm und weniger als 50 nm umfasst.

5. Verglasung (100) mit variabler flüssigkristallinduzierter Streuung nach einem der vorhergehenden Ansprüche, **dadurch gekennzeichnet, dass** die zweite Sperrschicht die letzte Sperrschicht ist oder dass der Stapel (3) auf der zweiten Sperrschicht eine andere Sperrschicht, eine sogenannte Sperr-Deckschicht, auf Basis von Siliciumnitrid mit einer Dicke e'₃ von mindestens 5 nm und weniger als 50 nm umfasst.

6. Verglasung (100) mit variabler flüssigkristallinduzierter Streuung nach einem der vorhergehenden Ansprüche, **dadurch gekennzeichnet, dass** der Stapel (3) zwischen der TCO-Schicht und der ersten Sperrschicht eine Sperrschicht, eine sogenannte andere Sperr-Unterschicht, auf Basis von Siliciumoxid mit einer Dicke e'₄ von mindestens 5 nm und weniger als 50 nm umfasst.

7. Verglasung (100) mit variabler flüssigkristallinduzierter Streuung nach einem der vorhergehenden Ansprüche, **dadurch gekennzeichnet, dass** der Stapel (3) zwischen der TCO-Schicht und der ersten Sperrschicht in dieser Reihenfolge umfasst:
- eine dritte Sperrschicht auf Basis von Siliciumnitrid mit einer Dicke e₃ von mindestens 5 nm und weniger als 50 nm,
- eine vierte Sperrschicht auf Basis von Siliciumoxid mit einer Dicke e₄ von mindestens 5 nm und weniger als 50 nm,
und gegebenenfalls umfasst der Stapel zwischen der TCO-Schicht und der dritten Sperrschicht mindestens einmal die folgende Sequenz: Sperrschicht auf Basis von Siliciumnitrid mit einer Dicke von mindestens 5 nm und weniger als 50 nm/Sperrschicht auf Basis von Siliciumoxid mit einer Dicke von mindestens 5 nm und weniger als 50 nm, wobei die Sequenz gegebenenfalls mindestens einmal wiederholt wird.

8. Verglasung (100) mit variabler flüssigkristallinduzierter Streuung nach einem der vorhergehenden Ansprüche, **dadurch gekennzeichnet, dass** der Stapel (3) in dieser Reihenfolge auf der Hauptfläche (11) unter der TCO-Schicht umfasst:
- eine erste Unterschicht auf Basis von Siliciumnitrid mit einer Dicke e_{y} von 5 bis 50 nm, vorzugsweise direkt auf der Hauptfläche,
- eine zweite Unterschicht auf Basis von Siliciumoxid mit einer Dicke e_{z} von 10 bis 50 nm.

9. Verglasung mit variabler flüssigkristallinduzierter Streuung nach Anspruch 8, **dadurch gekennzeichnet, dass** e_{y} 10 bis 35 nm, e_{z} 20 bis 50 nm, e₁ 10 bis 40 nm und e₂ 40 bis 70 nm beträgt.

10. Verglasung (100) mit variabler flüssigkristallinduzierter Streuung nach einem der Ansprüche 8 oder 9, **dadurch gekennzeichnet, dass** der Stapel (3) zwischen der ersten Unterschicht und der zweiten Unterschicht eine Schicht, eine sogenannte Glättungsschicht, auf Basis eines Zink- und Zinnmischoxids mit einer Dicke er von mindestens 5 nm und weniger als 50 nm umfasst.

11. Verglasung (100) mit variabler flüssigkristallinduzierter Streuung nach einem der vorhergehenden Ansprüche, **dadurch gekennzeichnet, dass** der elektrisch leitende Träger direkt auf der zweiten Sperrschicht oder auf einer sogenannten Schutzschicht liegt, wobei die Schicht Flüssigkristalle in Polymermaterial enthält.

12. Verglasung mit variabler flüssigkristallinduzierter Streuung nach einem der vorhergehenden Ansprüche, **dadurch gekennzeichnet, dass** das Substrat (1) ein möglicherweise getöntes Mineralglas ist.

13. Verglasung mit variabler flüssigkristallinduzierter Streuung nach einem der vorhergehenden Ansprüche, **dadurch gekennzeichnet, dass** die Schicht auf Basis von transparentem elektrisch leitendem Oxid, die sogenannte TCO-Schicht, aus einer Schicht auf Basis von Zinkoxid, das vorzugsweise mit Aluminium und/oder Gallium dotiert ist, einer Schicht auf Basis von Zinnoxid, das vorzugsweise mit Fluor und/oder Antimon dotiert ist, einer Schicht auf Basis von Zinn- und Indiumoxid, einer Schicht auf Basis von Zinn- und Zinkoxid, einer Schicht auf Basis von Zink-, Zinn- und Indiumoxid ausgewählt ist.

14. Verglasung mit variabler flüssigkristallinduzierter Streuung nach einem der vorhergehenden Ansprüche, **dadurch gekennzeichnet, dass** die Schicht auf Basis von transparentem elektrisch leitendem Oxid, eine sogenannte TCO-Schicht, eine Schicht auf Basis von Zinn- und Indiumoxid ist.

15. Verglasung (100) mit variabler flüssigkristallinduzierter Streuung nach einem der vorhergehenden Ansprüche, **dadurch gekennzeichnet, dass** sie aufweist:
- die Schicht (5), die Flüssigkristalle enthält, die in Tröpfchen in Polymermaterial dispergiert sind,
- einen zweiten elektrisch leitenden Träger, umfassend ein anderes Substrat (2), das mit einem anderen Stapel (4) mit mindestens einer anderen Elektrode dotiert ist, wobei der Stapel mit der Schicht aus Flüssigkristallen in Kontakt steht.

16. Verglasung (100) mit variabler flüssigkristallinduzierter Streuung nach dem vorhergehenden Anspruch, **dadurch gekennzeichnet, dass** die andere Elektrode umfasst:
- eine Schicht auf Basis von transparentem elektrisch leitendem Oxid, eine sogenannte TCO-Schicht
- eine erste Sperrschicht auf Basis von Siliciumnitrid mit einer Dicke e₁ von mindestens 5 nm,
und der andere Stapel umfasst oberhalb der ersten Sperrschicht eine zweite Sperrschicht auf Basis von Siliciumoxid mit einer Dicke e₂ von mindestens 30 nm, wobei die Dicke e₁ kleiner oder gleich e₂ ist, und/oder e₁ kleiner als 80 nm ist, wobei die kumulative Dicke e_{b} der ersten und zweiten Sperrschicht größer oder gleich 50 nm, und kleiner als 150 nm ist.

## Claims

1. Glazing unit (100) having liquid-crystal-mediated variable scattering properties, comprising an electrically conductive support having a first transparent substrate (1) having a main face (11) comprising a multilayer (3) of thin films, namely, in this order:
- an electrode comprising a film, called the TCO film, based on transparent electrically conductive oxide; and
- a silicon-nitride-based first barrier film having a thickness e₁ of at least 5 nm,
And over the support a layer comprising liquid crystals dispersed in a polymer
**characterized in that** the multilayer comprises, above the first barrier film, a silicon-oxide-based second barrier film having a thickness e₂ of at least 30 nm, and **in that** the thickness e₁ is smaller than or equal to e₂ and/or e₁ is smaller than 80 nm,
and **in that** the cumulative thickness e_{b} of the first and second barrier films is larger than or equal to 50 nm and smaller than 150 nm.

2. Glazing unit (100) having liquid-crystal-mediated variable scattering properties according to Claim 1, **characterized in that** e₂ lies in a range extending from 30 to 100 nm, e_{b} preferably being smaller than or equal to 120 nm.

3. Glazing unit (100) having liquid-crystal-mediated variable scattering properties according to one of the preceding claims, **characterized in that** e₂ lies in a range extending from 35 nm to 80 nm and e₁ lies in a range extending from 10 nm to 50 nm.

4. Glazing unit (100) having liquid-crystal-mediated variable scattering properties according to one of the preceding claims, **characterized in that** the multilayer (3) comprises, between the first and second barrier films, a barrier film called the additional barrier film, this additional barrier film being based on zinc tin oxide and having a thickness e_{5'} of at least 5 nm and smaller than 50 nm.

5. Glazing unit (100) having liquid-crystal-mediated variable scattering properties according to one of the preceding claims, **characterized in that** the second barrier film is the last barrier film or **in that** the multilayer (3) comprises, on the second barrier film, another barrier film called the over barrier film, this over barrier film being based on silicon nitride and having a thickness e'₃ of at least 5 nm and smaller than 50 nm.

6. Glazing unit (100) having liquid-crystal-mediated variable scattering properties according to one of the preceding claims, **characterized in that** the multilayer (3) comprises, between the TCO film and the first barrier film, another barrier film called the under barrier film, this under barrier film being based on silicon oxide and having a thickness e'₄ of at least 5 nm and smaller than 50 nm.

7. Glazing unit (100) having liquid-crystal-mediated variable scattering properties according to one of the preceding claims, **characterized in that** the multilayer (3) comprises, between the TCO film and the first barrier film, in this order:
- a silicon-nitride-based third barrier film having a thickness e₃ of at least 5 nm and smaller than 50 nm; and
- a silicon-oxide-based fourth barrier film having a thickness e₄ of at least 5 nm and smaller than 50 nm, and optionally the multilayer comprises, between the TCO film and the third barrier film, at least once the following sequence: silicon-nitride-based barrier film having a thickness of at least 5 nm and smaller than 50 nm/silicon-oxide-based barrier film having a thickness of at least 5 nm and smaller than 50 nm, the sequence optionally being repeated at least once.

8. Glazing unit (100) having liquid-crystal-mediated variable scattering properties according to one of the preceding claims, **characterized in that** the multilayer (3) comprises, in this order, on the main face (11), under the TCO film:
- a silicon-nitride-based first underfilm having a thickness e_{y} of 5 to 50 nm, preferably directly on the main face; and
- a silicon-oxide-based second underfilm having a thickness e_{z} of 10 to 50 nm.

9. Glazing unit (100) having liquid-crystal-mediated variable scattering properties according to Claim 8, **characterized in that** e_{y} is between 10 and 35 nm, e_{z} is between 20 and 50 nm, e₁ is between 10 and 40 nm and e₂ is between 40 and 70 nm.

10. Glazing unit (100) having liquid-crystal-mediated variable scattering properties according to either one of Claims 8 and 9, **characterized in that** the multilayer (3) comprises, between the first underfilm and the second underfilm a film called the smoothing film, this smoothing film being based on mixed zinc tin oxide and having a thickness e_{f'} of at least 5 nm and smaller than 50 nm.

11. Glazing unit (100) having liquid-crystal-mediated variable scattering properties according to one of the preceding claims, **characterized in that** the electrically conductive support comprises, directly on the second barrier film or on what is called a protective film, the layer comprising liquid crystals dispersed in a polymer.

12. Glazing unit (100) having liquid-crystal-mediated variable scattering properties according to one of the preceding claims, **characterized in that** the substrate (1) is a sheet of optionally tinted mineral glass.

13. Glazing unit (100) having liquid-crystal-mediated variable scattering properties according to one of the preceding claims, **characterized in that** the film based on transparent electrically conductive oxide called TCO film is chosen from a film based on zinc oxide that is preferably doped with aluminium and/or gallium, a film based on tin oxide preferably doped with fluorine and/or antimony, a film based on indium tin oxide, a film based on zinc tin oxide, and a film based on indium zinc tin oxide.

14. Glazing unit (100) having liquid-crystal-mediated variable scattering properties according to one of the preceding claims, **characterized in that** the film based on transparent electrically conductive oxide called TCO film is a film based on indium tin oxide.

15. Glazing unit (100) having liquid-crystal-mediated variable scattering properties, according to one of the preceding claims **characterized in that** it comprises:
the layer (5) comprising liquid crystals dispersed in droplets in a polymer; and
- a second electrically conductive support, comprising another substrate (2) equipped with another multilayer (4) containing at least one other electrode, said multilayer making contact with the liquid-crystal layer.

16. Glazing unit (100) having liquid-crystal-mediated variable scattering properties, according to one of the preceding claims **characterized in that** other electrode
- an electrode comprising a film, called the TCO film, based on transparent electrically conductive oxide; and
- a silicon-nitride-based first barrier film having a thickness e₁ of at least 5 nm,
And the other multilayer comprises, above the first barrier film, a silicon-oxide-based second barrier film having a thickness e₂ of at least 30 nm,
and **in that** the thickness e₁ is smaller than or equal to e₂ and/or e₁ is smaller than 80 nm,
and **in that** the cumulative thickness e_{b} of the first and second barrier films is larger than or equal to 50 nm and smaller than 150 nm.
